(19) **Europäisches Patentamt / European Patent Office / Office européen des brevets**

(11) **EP 4 391 786 B1**

(12) **FASCICULE DE BREVET EUROPEEN**

(45) Date de publication et mention de la délivrance du brevet:
**03.12.2025 Bulletin 2025/49**

(21) Numéro de dépôt: **23218436.6**

(22) Date de dépôt: **20.12.2023**

(51) Classification Internationale des Brevets (IPC):
*H10N 70/00* (2023.01)    *H10N 70/20* (2023.01)
*H10B 63/10* (2023.01)    *H10B 63/00* (2023.01)

(52) Classification Coopérative des Brevets (CPC):
H10N 70/231; H10B 63/10; H10B 63/24;
H10N 70/043; H10N 70/063; H10N 70/826;
H10N 70/8825; H10N 70/8828

(54) **UN DISPOSITIF MÉMOIRE À CHANGEMENT DE PHASE ET UN PROCÉDÉ DE FABRICATION D'UN DISPOSITIF MÉMOIRE À CHANGEMENT DE PHASE**

EINE PHASENWECHSELSPEICHERVORRICHTUNG UND EIN VERFAHREN ZUR HERSTELLUNG EINER PHASENWECHSELSPEICHERVORRICHTUNG

A PHASE CHANGE MEMORY DEVICE AND A METHOD OF MANUFACTURING A PHASE CHANGE MEMORY DEVICE

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **21.12.2022 FR 2214054**

(43) Date de publication de la demande:
**26.06.2024 Bulletin 2024/26**

(73) Titulaire: **Commissariat à l'Energie Atomique et aux Energies Alternatives 75015 Paris (FR)**

(72) Inventeurs:
• **BOURGEOIS, Guillaume
  38054 Grenoble Cedex 09 (FR)**
• **NAVARRO, Gabriele
  38054 Grenoble Cedex 09 (FR)**

(74) Mandataire: **Hautier IP
20, rue de la Liberté
06000 Nice (FR)**

(56) Documents cités:
CN-A- 112 786 784     US-A1- 2012 295 398
US-A1- 2020 052 039     US-A1- 2020 075 675
US-B1- 10 454 025

## Description

## DOMAINE TECHNIQUE

La présente invention concerne le domaine des dispositifs mémoires à changement de phase. Elle trouve pour application particulièrement avantageuse le domaine des dispositifs mémoire à base d'au moins une couche chalcogénure, par exemple à base de germanium, sélénium et tellure (GeSbTe, aussi désigné matériau GST).

## ETAT DE LA TECHNIQUE

Les dispositifs mémoires représentent des enjeux cruciaux dans de nombreuses applications, par exemples pour le type de mémoire communément désignée par le terme anglais Storage Class Memory (SCM), les mémoires embarquées pour l'automobile, ou les applications neuromorphiques. Dans ce contexte, les mémoires résistives représentent de très bons candidats pour supporter ou remplacer la mémoire Flash. Les mémoires résistives présentent en effet des avantages significatifs en termes de vitesse et de mise à l'échelle, c'est-à-dire la réduction des dimensions de la cellule unitaire mémoire, et de la distance entre deux points mémoires, ce qui a pour effet d'augmenter la densité de points mémoires dans les matrices de mémoire. Parmi les mémoires résistives, les mémoires à changement de phase (communément abrégées PCM, de l'anglais Phase Change Memory) représentent la technologie de mémoire résistive non volatile parmi les plus mûres et à un stade de développement et de production avancé.

Les mémoires à changement de phase comprennent typiquement deux états de programmation obtenus à partir d'une couche à base d'un matériau chalcogénure formant une couche dite « mémoire » et présentant un état amorphe et un état cristallin :

- programmation « reset » ou de façon équivalente HRS, de l'anglais High Resistive State, (que l'on peut traduire par état de haute résistivité), qui se base sur la fonte de la totalité ou d'une partie de la couche chalcogénure, lors d'une impulsion électrique permettant d'atteindre la température de fusion du matériau par effet Joule. Ensuite la partie fondue du matériau chalcogénure est figée dans un état amorphe par refroidissement soudain, obtenu par réduction rapide du courant. L'état amorphe du matériau chalcogénure est très peu conducteur électriquement. La programmation reset permet de stocker l'information « 0 », avec le stockage d'une résistance élevée dans le dispositif PCM.
- programmation « set » ou de façon équivalente LRS, de l'anglais Low Resistive State, (que l'on peut traduire par état de faible résistivité), qui se base sur une fonte partielle ou totale du matériau chalcogénure lors d'une impulsion électrique. Ensuite, le matériau chalcogénure est cristallisé par un refroidissement graduel obtenu par réduction graduelle du courant. L'état cristallin du matériau chalcogénure est un meilleur conducteur électrique que l'état amorphe. La programmation set permet de stocker l'information « 1 », avec le stockage d'une résistance faible dans le dispositif PCM.

La couche mémoire peut en outre être complétée par une deuxième couche chalcogénure dite « sélectrice », incorporée dans un module sélecteur ou commutateur du dispositif PCM (communément désigné en anglais par le terme ovonic threshold switch, OTS, que l'on peut traduire par commutateur de seuil ovonique). La deuxième couche chalcogénure sous l'état amorphe, présente des états de conductivité électrique différents avec l'application d'une tension seuil et d'une tension d'initialisation. Au-delà de la tension de seuil, la deuxième couche chalcogénure présente une faible résistivité, permettant le passage d'un flux élevé de courant électrique. Le courant électrique permet de programmer et de lire le dispositif PCM sélectionné dans un réseau, sans programmation indésirable des dispositifs adjacents. La tension de seuil est la tension de commutation de la couche sélectrice pour autoriser le passage du courant. La tension de seuil peut être utilisée pour différencier l'état set et l'état reset. La tension de d'initialisation est la tension de seuil nécessaire à la première commutation, typiquement supérieure aux tensions de seuil subséquentes.

Parmi les spécifications demandées, selon les applications l'on va rechercher une stabilité de la phase amorphe à haute température, une fiabilité avec un taux d'erreur de programmation typiquement inférieur à la ppm ($10^{-6}$), une endurance typiquement supérieure à $10^9$ cycles et/ou des vitesses de cristallisation rapides.

Cependant, certaines étapes de fabrication d'un dispositif PCM ont un impact négatif sur ses performances. Notamment, la gravure ou structuration (couramment désignée par le terme anglais de « patterning ») du dispositif PCM affecte la composition des couches chalcogénures et peut engendrer une recristallisation non souhaitée de ces couches, une accélération des phénomènes de ségrégation et une mauvaise fonctionnalité du dispositif PCM pour des dimensions critiques trop faibles.

Même en encapsulant le dispositif PCM, on constate que celui-ci présente des performances dégradées. Notamment, on remarque fréquemment la présence d'un pic d'oxygène au niveau des flancs du dispositif.

Les solutions connues ne proposent donc pas de solution satisfaisante pour réduire la dimension d'un point mémoire sans dégrader significativement ses performances (voir par exemple les publications US 2020/052039 A1, US 2020/075675 A1, US 10 454 025 B1, CN 112786784 A, US 2012/295398 A1).

Un objet de la présente invention est donc de proposer une solution améliorant les propriétés d'un dispositif mémoire à changement de phase.

Les autres objets, caractéristiques et avantages de la présente invention apparaîtront à l'examen de la description suivante et des dessins d'accompagnement. Il est entendu que d'autres avantages peuvent être incorporés.

RESUME

Pour atteindre cet objectif, un premier aspect de l'invention concerne un dispositif mémoire à changement de phase comprenant un empilement comprenant un point mémoire selon la revendication indépendante de dispositif 1.

Un deuxième aspect de l'invention concerne un procédé de fabrication d'un dispositif mémoire à changement de phase selon la revendication indépendante de procédé 9.

Suite à la gravure de structuration de l'empilement pour former le point mémoire et à l'encapsulation de ce dernier, le point mémoire et notamment le tronçon chalcogénure présentent de nombreux défauts. On compte notamment parmi eux des défauts structurels provoqués par la gravure de structuration, et une oxydation des espèces chalcogénures du fait de la remise à l'air inévitable du point mémoire avant son encapsulation. Ces étapes de gravure et d'encapsulation sont cependant extrêmement courantes voire inévitables lors de la production de dispositifs mémoires.

L'implantation telle que décrite ci-dessus permet de supprimer ou du moins réduire la quantité de ces défauts et notamment de fiabiliser l'interface entre le tronçon chalcogénure et la couche d'encapsulation. Elle permet notamment de détruire les liaisons oxyde formées avec les espèces chalcogénures et de former à la place des liaisons entre les espèces chalcogénure et l'espèce dopante, par exemple des liaisons Ge-C.

L'implantation proposée depuis la surface latérale du point mémoire permet également d'améliorer la propreté de l'interface entre le tronçon chalcogénure et la couche d'encapsulation, permettant d'éviter les effets parasites de dégénération de l'espèce chalcogénure au niveau de ladite interface, et d'améliorer l'adhérence entre le point mémoire et la couche d'encapsulation.

Grâce à l'inclinaison de l'implantation, le procédé permet le traitement de l'interface entre le point mémoire et la couche d'encapsulation sans modification du matériau chalcogénure, ce que ne permet pas une implantation verticale.

L'implantation proposée a également pour avantage de réduire le stress du tronçon chalcogénure amorphe au niveau de l'interface avec la couche d'encapsulation. Cela a pour bénéfice direct une relaxation des contraintes et donc une limitation de la quantité de défauts structuraux pouvant apparaître ainsi qu'une meilleure robustesse du dispositif. Cela a également un impact positif sur la durée de vie du dispositif, notamment en termes d'endurance.

Dans le cadre de la présente invention, le dopage de la couche chalcogénure est réalisé par implantation ionique sur une couche chalcogénure déjà formée. L'implantation ionique permet un meilleur contrôle de la localisation de l'espèce dopante dans la couche chalcogénure, et ce notamment pour des concentrations plus faibles que par co-pulvérisation.

Lors du développement de l'invention, il a en outre été mis en évidence que, de manière surprenante, l'implantation ionique induit une redistribution structurale de la couche chalcogénure (par le passage des ions et leur implantation), ce qui permet d'améliorer ses propriétés.

Les performances du dispositif PCM sont ainsi améliorées. La programmation de l'état SET et l'endurance du dispositif PCM peuvent notamment être améliorées.

Cette solution se démarque clairement des solutions mettant en oeuvre un dépôt par co-pulvérisation, qui incitent au contraire à adapter les paramètres de dépôt par pulvérisation pour améliorer les propriétés d'un dispositif PCM dopé en carbone.

Les avantages décrits pour le procédé de fabrication du dispositif s'étendent au dispositif en lui-même, qui présente notamment une bonne qualité d'interface entre le point mémoire et la couche d'encapsulation.

**BREVE DESCRIPTION DES FIGURES**

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La figure 1 représente une vue en coupe transversale en microscopie électronique à balayage illustrant selon un exemple l'emplacement d'un dispositif PCM entre les niveaux métalliques en fin de ligne de fabrication (communément désigné en anglais par back-end of line, ou simplement back-end).

La figure 2 représente un schéma en perspective d'un point mémoire selon un exemple de réalisation.

Les figures 3A à 3I représentent un premier mode de réalisation du procédé selon l'invention. La figure 3A illustre la fourniture d'un empilement comprenant une couche inférieure, une couche chalcogénure et une couche supérieure.

La figure 3B illustre la formation d'un masque de gravure sur la face supérieure de l'empilement.

La figure 3C représente la formation d'ouvertures dans le masque de gravure.

La figure 3D illustre la gravure de structuration de l'empilement au travers du masque de gravure, permettant d'obtenir un point mémoire comprenant une électrode inférieure, un tronçon chalcogénure et une électrode supérieure.

La figure 3E illustre le retrait du masque de gravure.

La figure 3F représente une étape d'encapsulation du point mémoire par une couche d'encapsulation.

La figure 3G illustre une étape d'implantation du point mémoire et tout particulièrement du tronçon chalcogénure au travers de la couche d'encapsulation.

La figure 3H représente le dispositif mémoire après implantation.

La figure 3I représente un détail de la figure 3F, figurant notamment le tronçon chalcogénure dont sa portion dopée.

Les figures 4A à 4E représentent un deuxième mode de réalisation du procédé selon l'invention. La figure 4A illustre la fourniture d'un empilement comprenant une couche inférieure, une première couche chalcogénure, une couche intermédiaire, une deuxième couche chalcogénure et une couche supérieure.

La figure 4B illustre le point mémoire obtenu après une gravure de structuration de l'empilement illustré à la figure 4A. Le point mémoire comprend une électrode inférieure, un premier tronçon chalcogénure, une électrode intermédiaire, un deuxième tronçon chalcogénure et une électrode supérieure.

La figure 4C représente une étape d'encapsulation du point mémoire par une couche d'encapsulation.

La figure 4D illustre une étape d'implantation du point mémoire et tout particulièrement des tronçons chalcogénures au travers de la couche d'encapsulation.

La figure 4E représente le dispositif mémoire après implantation.

Les figures 5A, 5B et 5C représentent des schémas, respectivement en perspective, en vue de face et en vue de dessus, d'un dispositif PCM selon un exemple de réalisation.

La figure 6 est un graphique illustrant l'évolution de la concentration de différentes espèces dans une tranche du dispositif PCM comprenant une portion de la couche mémoire et de la couche d'encapsulation.

La figure 7 est un graphique illustrant les profils d'implantation obtenus pour deux énergies d'implantation différentes dans une tranche du dispositif PCM comprenant une portion de la couche mémoire et de la couche d'encapsulation.

La figure 8 est un graphique illustrant l'évolution de la résistivité de la couche mémoire du dispositif mémoire en fonction de la température, pour différentes valeurs d'énergie d'implantation et de dose implantée.

La figure 9 est un graphique illustrant la densité au sein de la couche mémoire du dispositif mémoire et l'épaisseur de couche mémoire impactée pour différentes énergies d'implantation et doses implantées.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Avantageusement, $20° \leq \theta_{impl} \leq 60°$.

Préférentiellement, la portion présente, selon toutes les directions d'un plan transversal perpendiculaire à la direction verticale, une dimension radiale $l_{125}$ avec $l_{125} \leq 20$ nm, de préférence $l_{125} \leq 10$ nm. Cela permet d'éviter que les performances du matériau chalcogénure soient altérées, ou du moins altérées dans des proportions trop importantes. Avantageusement, $l_{125} \geq 2$ nm, de préférence $l_{125} \geq 5$ nm.

Selon un mode de réalisation, l'au moins un tronçon chalcogénure comprend un premier tronçon chalcogénure et un deuxième tronçon chalcogénure :

-    le premier tronçon chalcogénure est disposé sur l'électrode inférieure, et destiné à former une couche dite mémoire, et
-    le deuxième tronçon chalcogénure est destiné à former une couche dite sélectrice, le deuxième tronçon chalcogénure étant séparé du premier tronçon chalcogénure par une électrode intermédiaire, et
-    l'implantation ionique est configurée de sorte que la portion du tronçon chalcogénure s'étende dans le premier tronçon chalcogénure et le deuxième tronçon chalcogénure.

Selon un exemple, l'espèce dopante implantée est au moins l'une parmi le carbone, le fluor, l'azote, l'indium, l'arsenic, l'aluminium, le germanium, le silicium, le chlore et le bore.

Selon un exemple, lors de l'implantation ionique, l'énergie d'implantation est supérieure ou égale à 1 keV, de préférence supérieure ou égale à 4 keV, de préférence supérieure ou égale à 10 keV, par exemple supérieure ou égale à 30 keV.

Selon un exemple, lors de l'implantation ionique, une dose d'espèce dopante implantée $D_{impl}$ supérieure à $10^{15}$ atomes/cm$^2$ est implantée.

Selon un mode de réalisation, on considère que le pourcentage atomique (ou concentration atomique) de l'espèce dopante dans la portion dopée d'un tronçon chalcogénure donné correspond au pourcentage atomique maximal constaté dans ce tronçon chalcogénure donné. Selon un mode de réalisation préféré, le pourcentage atomique dans la portion non dopée est inférieur ou égal à 30%, de préférence 20% voire 10% de ce pourcentage atomique maximal constatée dans le tronçon chalcogénure.

Selon un exemple, la portion dopée présente un gradient en espèce dopante depuis sa surface latérale jusqu'à la portion non dopée.

Selon un exemple, le pourcentage atomique de l'espèce dopante au sein de la portion dopée est sensiblement constant selon la direction d'empilement.

Selon un exemple, la portion non dopée présente une concentration atomique en espèce dopante strictement inférieure à 0,5%.

Selon l'invention, la couche d'encapsulation est à base d'au moins un matériau pris parmi : le SiN, le SiC et le SiCN.

Selon un exemple, le tronçon chalcogénure comprend au moins un élément chimique parmi le germanium Ge, l'antimoine Sb et le tellure Te.

Selon un exemple, le premier tronçon chalcogénure, ou couche mémoire, peut-être à base ou fait de tout matériau appartenant au diagramme ternaire du germanium Ge, antimoine Sb et tellure Te. Par exemple, ce matériau est choisi parmi $GeSb_2Te_4$, GeTe, $Sb_2Te_3$ et $Ge_7SbTe_2$.

Selon un exemple, le deuxième tronçon chalcogénure, ou couche sélectrice, comprend au moins un élément chimique parmi le sélénium, l'arsenic, le soufre, le silicium et l'aluminium. Selon un exemple, le deuxième tronçon chalcogénure, ou couche sélectrice, est à base ou fait d'un matériau choisi parmi les familles d'alliage GeSbSe, GeSe, AsSeSiGe, AsSe, SbSe, SiSe, AsTe, SiGeSe, AlTe, éventuellement dopé à l'azote N. Notons que les coefficients stœchiométriques entre les éléments chimiques de ces alliages peuvent varier, par exemple selon les applications visées.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un paramètre « sensiblement égal/supérieur/inférieur à » une valeur donnée, que ce paramètre est égal/supérieur/inférieur à la valeur donnée, à plus ou moins 10 %, près de cette valeur. On entend par un paramètre « sensiblement compris entre » deux valeurs données que ce paramètre est au minimum égal à la plus petite valeur donnée, à plus ou moins 10 %, près de cette valeur, et au maximum égal à la plus grande valeur donnée, à plus ou moins 10 %, près de cette valeur.

On entend par un substrat, une couche, une zone ou une portion « à base » d'un matériau A, un substrat, une couche, une zone ou une portion comprenant ce matériau A, par exemple à hauteur d'au moins 50%, et éventuellement d'autres matériaux, par exemple des éléments dopants.

Dans le cadre de l'invention, les énergies sont données en électronvolt, pour lequel 1 eV ≈ $1.602 \cdot 10^{-19}$ J, dans le système international des unités.

De façon tout à fait connue dans le domaine, la famille des chalcogènes désigne les éléments chimiques de la 16ème colonne du tableau périodique des éléments chimiques, ou de façon équivalente la colonne précédant celles des halogènes et des gaz nobles.

Dans la description détaillée qui suit, il pourra être fait usage de termes tels que « horizontal », « vertical », « longitudinal », « transversal », « supérieur », « inférieur ». Ces termes doivent être interprétés de façon relative en relation avec la position normale du dispositif PCM lors de sa fabrication. Par exemple, les notions « horizontal » et « longitudinal » correspondent à la direction d'extension principale des couches et tronçons, et notamment de la ou les couche(s) et tronçon(s) chalcogénure(s), du dispositif PCM.

On utilisera également un repère dont la direction longitudinale ou arrière/avant correspond à l'axe Y, la direction transversale ou droite/gauche correspond à l'axe X et la direction verticale ou bas/haut correspond à l'axe Z.

Le procédé de fabrication du dispositif PCM 1 va maintenant être décrit en références aux figures selon plusieurs exemples de réalisation.

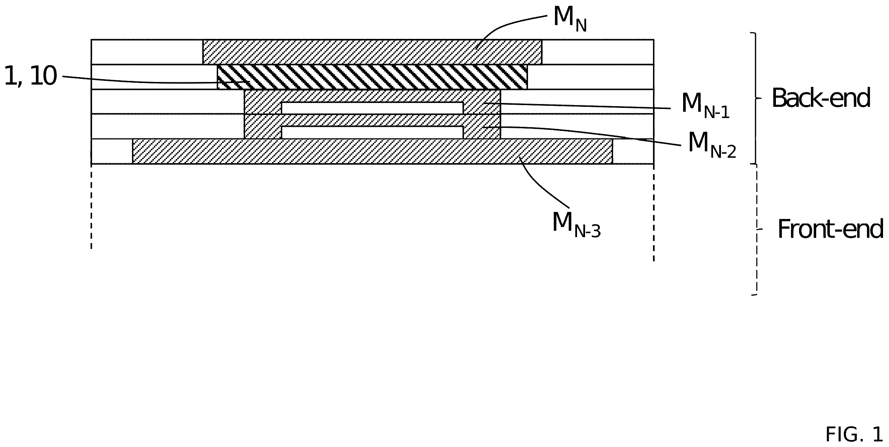

Un dispositif PCM 1 est typiquement fabriqué en fin de ligne de fabrication (communément désigné par back-end of line anglais, ou encore back-end). Le dispositif PCM 1 et son substrat peuvent être disposés entre deux niveaux métalliques M du back-end, notamment entre les deux derniers niveaux, par exemple entre MN et MN-1 comme illustré sur la figure 1. La position de la partie du dispositif fabriquée en début de ligne de fabrication (habituellement qualifiée de front-end) est indiquée par des pointillée en figure 1. Les intégrations peuvent plus généralement aller jusqu'à dix niveaux métalliques ou plus. Le terme de substrat ne signifie pas nécessairement une monocouche et peut comprendre un empilement de couches notamment dans le cadre d'une réalisation en back-end.

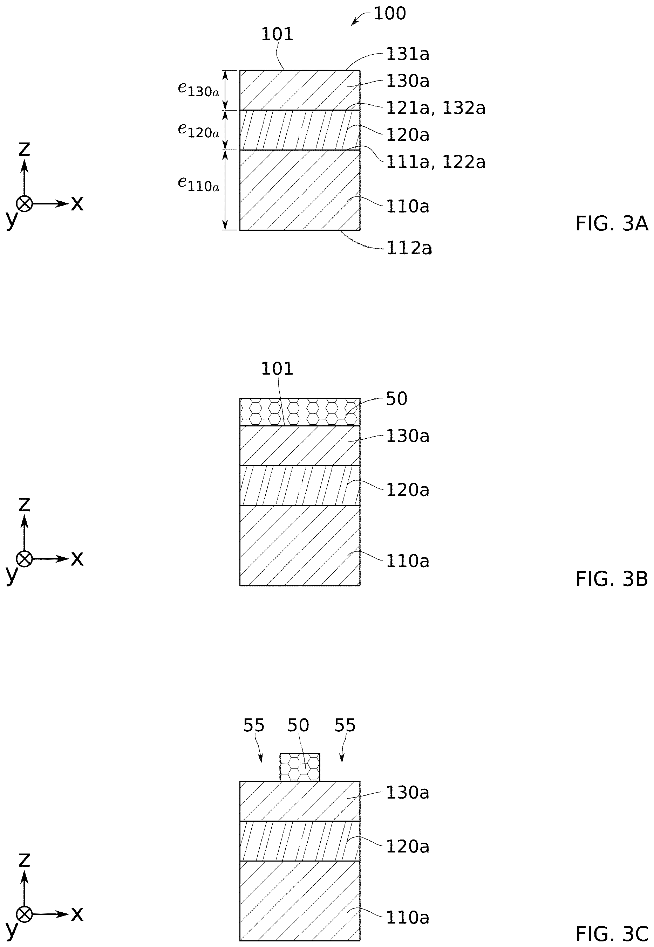

Un exemple de mise en oeuvre du procédé selon l'invention va maintenant être décrit en référence aux figures 3A à 3I.

Comme illustré en figure 3A, une première étape consiste en la fourniture d'un empilement 100 comprenant, empilées selon une direction d'empilement Z : une couche inférieure 110a, une couche chalcogénure 120a et une couche supérieure 130a. La couche chalcogénure 120a surmonte une face supérieure 111a de la couche inférieure 110a. De préférence, la face inférieure 122a de la couche chalcogénure 120a est au contact direct de la face supérieure 111a de la couche inférieure 110a. La couche supérieure 130a surmonte une face supérieure 121a de la couche chalcogénure 120a. De préférence, la face inférieure 132a de la couche supérieure 130a est au contact direct de la face supérieure 121a de la couche chalcogénure 120a. De préférence, les face supérieures 111a, 121a, 131a et inférieures 112a, 122a, 132a des couches inférieure 110a, chalcogénure 120a et supérieure 130a s'étendent selon des plans parallèles à un plan transversal XY perpendiculaire à la direction d'empilement Z.

Selon la direction d'empilement Z, les couches inférieure 110a, chalcogénure 120a et supérieure 130a présentent respectivement des épaisseurs $e_{110a}$, $e_{120a}$ et $e_{130a}$.

L'empilement 100 présente une face supérieure 101. De préférence, la face supérieure 101 de l'empilement 100 coïncide avec la face supérieure 131a de la couche supérieure 130a. La couche chalcogénure 120a est à base d'au moins un élément chimique de la famille des chalcogènes.

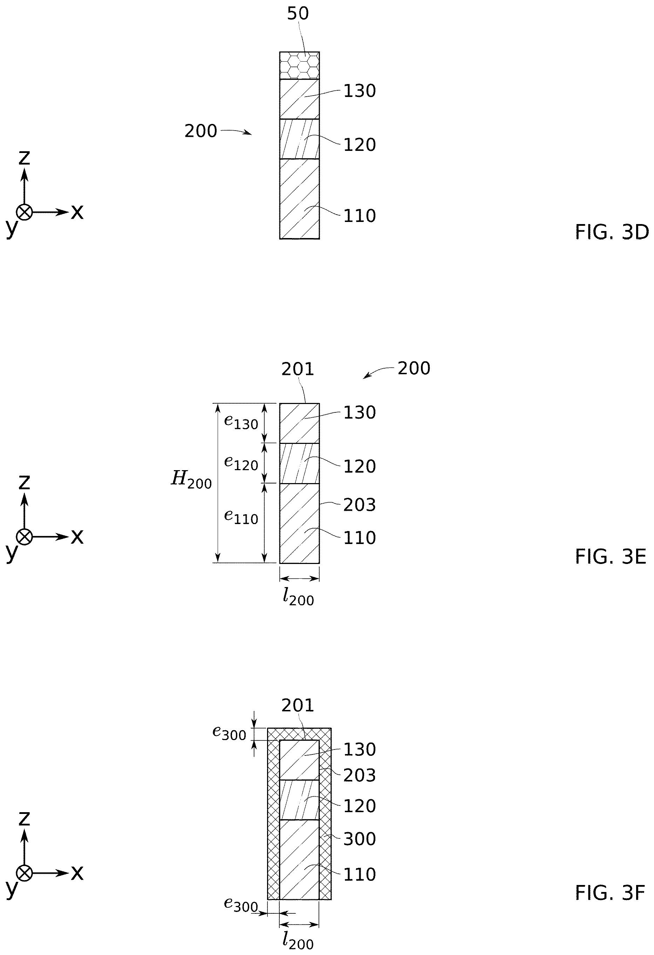

Une deuxième étape du procédé consiste en une gravure de structuration de l'empilement 100 de sorte à former un point mémoire 200 tel qu'illustré à la figure 3E.

La gravure de structuration peut se dérouler selon les étapes représentées aux figures 3B à 3E. Typiquement, un masque de gravure 50 est déposé sur la face supérieure 101 de l'empilement 100 (figure 3B). Des ouvertures 55 sont ensuite formées dans le masque de gravure 50. Une gravure est ensuite réalisée dans la couche supérieure 130a, la couche chalcogénure 120a et la couche inférieure 110a, au travers des ouvertures 55 du masque de gravure 50. Cette gravure traverse la couche supérieure 130a et la couche chalcogénure 120a sur toutes leurs épaisseurs respectives $e_{130a}$ et $e_{120a}$. La gravure de structuration peut s'arrêter dans la couche inférieure 110a, ou bien traverser entièrement cette dernière.

Suite à la gravure de structuration, on obtient un point mémoire 200 comprenant une électrode inférieure 110 formée dans au moins une partie de la couche inférieure 110a, un tronçon chalcogénure 120 formé dans la couche chalcogénure 120a et une électrode supérieure 130 formée dans la couche supérieure 130a.

Les épaisseurs $e_{110}$, $e_{120}$, et $e_{130}$ selon la direction d'empilement Z de ces électrodes et tronçon sont chacune sensiblement égale à l'épaisseur $e_{110a}$, $e_{120a}$, $e_{130a}$ et $e_{120a}$ de la couche à partir de laquelle ils ont été formés.

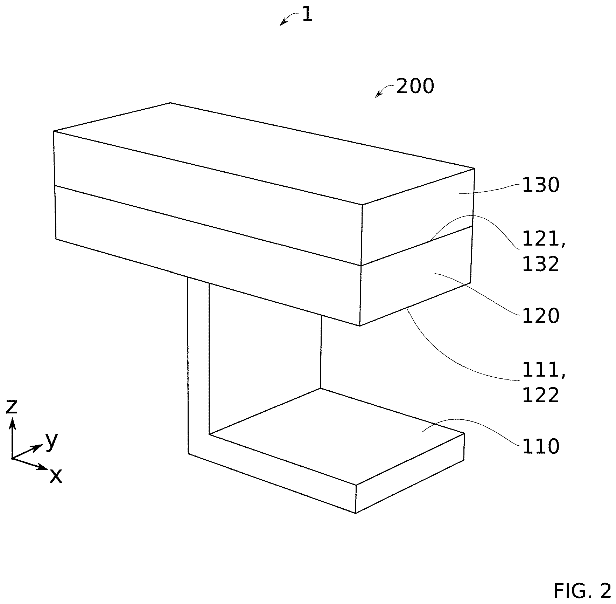

Le point mémoire 200 présente une face supérieure 201 s'étendant sensiblement dans le même plan que la face supérieure 101 de l'empilement 100 à partir duquel le point mémoire 200 a été formé. La face supérieure 201 s'étend ainsi de préférence dans un plan sensiblement parallèle au plan transversal XY. Le point mémoire 200 présente également une surface latérale 203 s'étendant à partir de sa face supérieure 201 et sur toute sa hauteur $H_{200}$. La géométrie de la surface latérale du point mémoire 200 dépend notamment des applications visées. Si le point mémoire 200 présente la forme d'un cylindre, sa surface latérale 203 correspond à la surface définie par les droites génératrices dudit cylindre et s'étendant sur sa hauteur $H_{200}$. Cela est notamment le cas lorsque les différents tronçons 110, 120, 130 composant le point mémoire 200 ont la même projection dans le plan transversal XY. La surface latérale 203 du point mémoire 200 peut également être plus complexe, notamment lorsque, comme dans l'exemple illustré à la figure 2, les différents tronçons 110, 120, 130 composant le point mémoire 200 n'ont pas la même projection dans le plan transversal XY. La surface latérale 203 comprend alors typiquement une pluralité de flancs s'étendant chacun principalement dans un plan parallèle à un plan généré par deux des trois axes X, Y et Z.

Le point mémoire présente par ailleurs selon toute direction du plan transversal XY une dimension radiale $l_{200}$. $l_{200}$ est typiquement supérieur à 10 nm et/ou inférieur à 100 nm.

L'intégralité ou une partie seulement du tronçon chalcogénure 120 est configurée pour changer de phase lors de l'utilisation du dispositif 1. Elle peut être propre à passer d'un état amorphe à un état cristallin ou inversement. Notamment, le tronçon chalcogénure 120 peut être propre à passer d'un état amorphe à un état cristallin ou inversement lorsque le tronçon chalcogénure 120 est une couche dite « mémoire ». Le passage entre l'état amorphe et l'état cristallin permet de stocker un état reset de haute résistivité à l'état amorphe ou un état set de faible résistivité à l'état cristallin dans une couche dite « mémoire ». La résistivité à l'état reset est supérieure à la résistivité à l'état set.

Comme illustré aux figures 3D à 3I, le tronçon chalcogénure 120 peut comprendre une unique couche, la couche mémoire, c'est à dire qu'il n'y a pas deux tronçons chalcogénures séparés par une couche autre qu'un tronçon chalcogénure, par exemple une électrode. Par exemple, dans ce cas, le dispositif 1 ne comprend pas de couche sélectrice décrite ultérieurement. Dans ce cas, de préférence, l'intégralité du tronçon chalcogénure 120 est configurée pour changer de phase lors de l'utilisation du dispositif. Il est également possible que seule une partie du tronçon chalcogénure 120 soit configurée pour changer de phase, par exemple dans le cas d'une programmation dans un état intermédiaire.

Selon un exemple, l'électrode inférieure 110 peut être une électrode configurée pour apporter l'impulsion électrique au tronçon chalcogénure 120 pour son passage d'un état à l'autre. L'électrode inférieure 110 peut être une électrode désignée par le terme de « heater » en anglais. Typiquement, une électrode « heater » présente une surface de contact avec le tronçon chalcogénure 120 réduite par rapport à la surface de contact entre le tronçon chalcogénure 120 et l'électrode supérieure 130. Notons qu'on peut prévoir que l'électrode inférieure 110 présente une géométrie donnée, et que l'électrode supérieure 130 présente une géométrie donnée, non nécessairement distinctes entre elles.

L'électrode supérieure 130 est généralement désignée par le terme de « top électrode ». De préférence, le masque de gravure 50 est retiré après la gravure de structuration, comme illustré par le passage de la figure 3D à la figure 3E.

Suite à la gravure de structuration, le point mémoire 200 est encapsulé par une couche d'encapsulation 300. La couche d'encapsulation 300 est au contact de la face supérieure 201 du point mémoire 200 et d'au moins une partie de sa surface latérale 203 s'étendant depuis la face supérieure 201. La couche d'encapsulation 300 est au contact de la face supérieure 201 et de la surface latérale 203 du point mémoire 200. De préférence, la couche d'encapsulation 300 recouvre l'intégralité de la surface latérale 203 du point mémoire 200. La couche d'encapsulation 300 présente une épaisseur $e_{300}$ déposée de manière conforme sur la surface latérale 203 et la face supérieure 201 du point mémoire 200. L'épaisseur $e_{300}$ de la couche d'encapsulation 300 est avantageusement comprise entre 10 et 30 nm, elle peut être par exemple sensiblement égale à 20 nm.

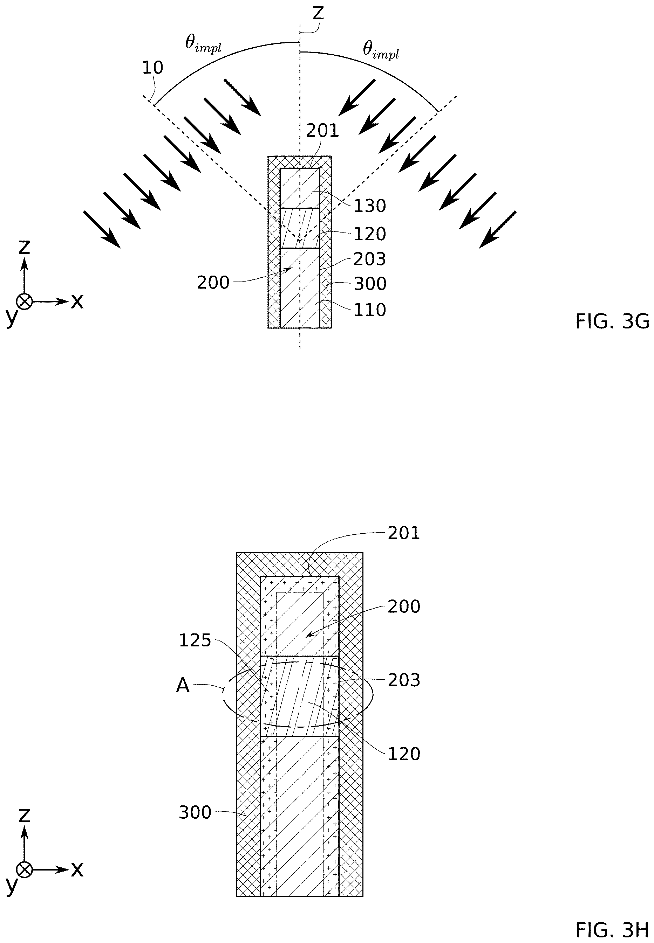

Le procédé de fabrication selon l'invention du dispositif PCM 1 prévoit, après l'encapsulation du point mémoire 200, une étape, illustrée en figure 3G, d'implantation d'une espèce dite dopante dans le point mémoire 200 au travers de la couche d'encapsulation 300. L'espèce dopante est choisie parmi le carbone, le fluor, l'azote, l'indium, l'arsenic, l'aluminium, le germanium, le silicium, le chlore ou encore le bore. L'implantation ionique est par exemple réalisée dans la chambre de réaction d'un réacteur d'implantation, par exemple un implanteur ionique à faisceau d'ions.

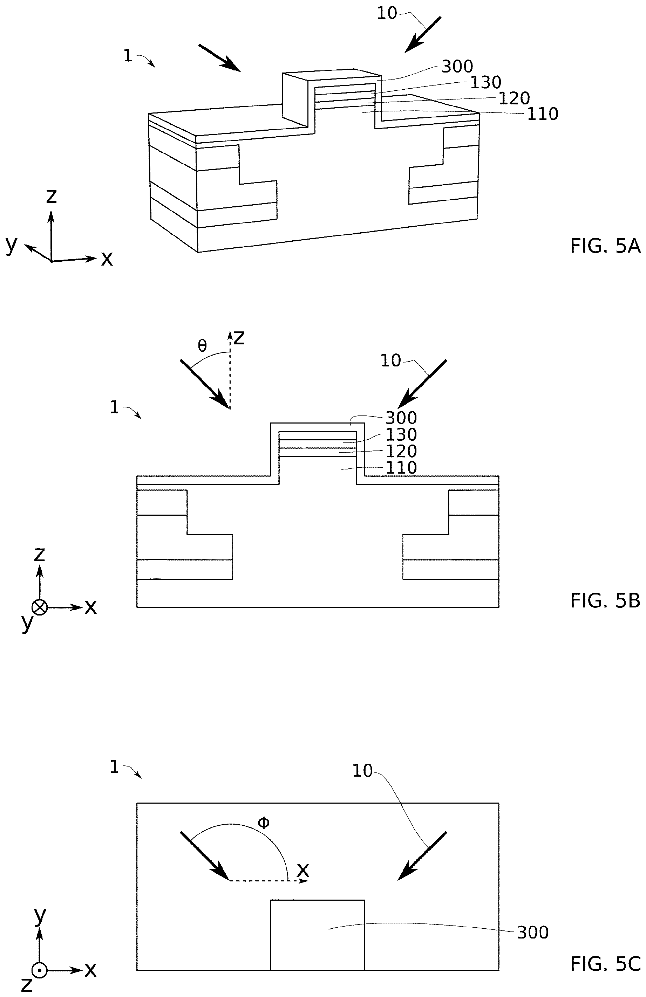

L'implantation de l'espèce dopante est réalisée selon une direction d'implantation 10 repérée dans l'espace par un premier angle $\theta$ mesuré par rapport à la direction d'empilement Z et par un deuxième angle $\Phi$ mesuré par rapport à l'axe X, comme illustré sur les figures 5B et 5C respectivement.

Une particularité de l'invention réside en ce que la direction d'implantation 10 forme un angle dit d'implantation $\theta_{impl}$ non nul avec la direction d'empilement Z. L'angle d'implantation $\theta_{impl}$ est supérieur ou égal à 25°, avantageusement supérieur ou égal à 40°.

De cette façon, les espèces dopantes sont implantées dans le point mémoire 200 non seulement à partir de sa face supérieure 201 mais également à partir de sa surface latérale 203.

L'inclinaison par rapport à la verticale de la direction d'implantation 10 permet notamment de cibler l'interface entre le point mémoire 200 et la couche d'encapsulation 300 au niveau de la surface latérale 203 du point mémoire 200. Certaines solutions existantes mettant en oeuvre un dopage de couches chalcogénures prévoient un dopage par co-pulvérisation de l'espèce chalcogénure et de l'élément dopant. Une telle co-pulvérisation ne permet cependant pas d'introduire l'élément dopant au niveau de l'interface entre le point mémoire 200 et la couche d'encapsulation 300.

L'angle $\Phi$ formé par la direction d'implantation 10 avec l'axe X est lui quelconque. On peut notamment envisager que cet angle varie au cours de l'étape d'implantation, ou bien que l'étape d'implantation soit réalisée pour plusieurs valeurs de $\Phi$. Cela permet de mieux répartir l'implantation au sein du point mémoire 200. Cela peut notamment permettre de réaliser une implantation à partir de l'intégralité de la surface latérale 203 du point mémoire 200.

L'implantation permet le dopage en espèce dopante d'au moins une portion 125, dite portion dopée, s'étendant au moins dans le tronçon chalcogénure 120, depuis la face latérale 203. On définit la portion dopée 125 comme la région du point mémoire 200 présentant, après l'étape d'implantation, une concentration atomique en espèce dopante supérieure ou égale à 0,5%. De préférence, cette concentration atomique est comprise entre 0,5% et 5%. Le tronçon chalcogénure comprend également une portion 126, dite portion non dopée, s'étendant depuis la portion dopée 125 et jusqu'au centre du tronçon chalcogénure 120. La portion non dopée 126 présente une concentration en espèce dopante inférieure à la portion dopée 125, voire nulle. De préférence, on définit la portion non dopée 126 comme la région du point mémoire 200 présentant, après l'étape d'implantation, une concentration atomique en espèce dopante strictement inférieure à 0,5%.

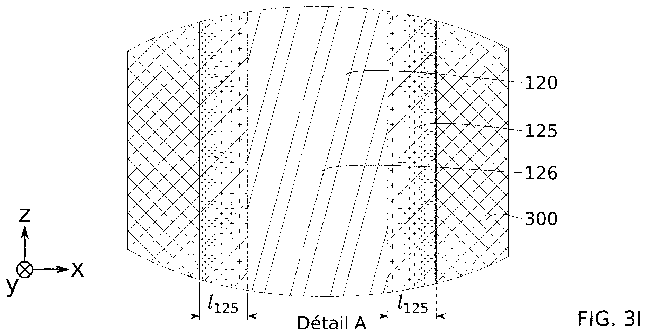

La portion dopée 125 du tronçon chalcogénure 120 s'étend de préférence selon la direction d'empilement Z sur au moins 50%, et de manière avantageuse au moins 75%, de l'épaisseur $e_{120}$ du tronçon chalcogénure 120. Préférentiellement, la portion dopée 125 s'étend sur toute l'épaisseur $e_{120}$ du tronçon chalcogénure 120. Comme illustré en figure 3I, la portion dopée 125 présente en projection selon toute direction du plan transversal XY une dimension radiale $l_{125}$. La dimension radiale $l_{125}$ est avantageusement supérieure ou égale à 2 nm, de préférence supérieure ou égale à 5 nm, sur toute la hauteur de la portion dopée 125. De préférence, la portion dopée 125 s'étend sur au moins 20% de $l_{200}$. Par ailleurs, la dimension radiale $l_{125}$ est avantageusement inférieure ou égale à 20 nm, de préférence inférieure ou égale à 10 nm, sur toute la hauteur de la portion dopée 125. De préférence, la portion dopée 125 s'étend sur 80% ou moins de la dimension radiale $l_{200}$ du point mémoire 200.

Comme illustré en figure 3H, l'implantation est typiquement configurée pour que la portion dopée 125 s'étende non seulement dans le tronçon chalcogénure 120 mais également dans l'électrode inférieure 110 et/ou l'électrode supérieure 130. La portion dopée 125 s'étend typiquement depuis la surface latérale 203 et la face supérieure 201. Avantageusement, elle s'étend selon la direction d'empilement Z sur au moins 50%, et de manière avantageuse au moins 75%, de la hauteur $H_{200}$ du point mémoire 200. Préférentiellement, la portion dopée 125 s'étend sur toute la hauteur $H_{200}$ du point mémoire 200.

Différents profils radiaux d'implantation peuvent être obtenus dans le tronçon chalcogénure 120 et plus généralement dans le point mémoire 200 grâce à un ajustement des paramètres d'implantation, notamment la dose et l'énergie d'implantation. Ces paramètres permettent notamment de contrôler la dimension radiale $l_{125}$.

Selon un exemple, le profil de concentration de l'espèce dopante dans la portion dopée 125 est homogène dans le plan transversal XY sur toute sa dimension radiale $l_{125}$. Un tel profil peut notamment être obtenu par une implantation à haute énergie, par exemple à 30 keV pour une implantation carbone. Selon un exemple alternatif, on peut prévoir que l'étape d'implantation ionique soit configurée pour former un profil de concentration de l'espèce dopante non uniforme dans le plan transversal. Pour cela, l'étape d'implantation ionique peut par exemple comprendre plusieurs implantations ioniques successives. Dans ce dernier exemple notamment, on considère de préférence que le pourcentage atomique en espèce dopante dans la portion dopée d'un tronçon chalcogénure correspond au pourcentage atomique maximal constaté dans ce tronçon chalcogénure. La portion dopée peut par exemple présenter un gradient en espèce dopante dont la valeur maximale correspond à ce pourcentage atomique maximal constaté. Le pourcentage atomique maximal en espèce dopante dans la portion non dopée est alors de préférence inférieur ou égal à 30%, de préférence 20% voire 10% de cette valeur maximale constatée dans la portion dopée. De préférence, dans tous les cas, le pourcentage atomique en espèce dopante dans la portion non dopée sera inférieur à un seuil donné, par exemple 0,5%.

Le profil de dopage en espèce dopante peut être déterminé par plusieurs méthodes telles que la spectroscopie Raman ou la spectroscopie rayons X, notamment associée à la microscopie électronique en transmission (couramment appelée TEM, de l'anglais « Transmission Electron Microscopy »).

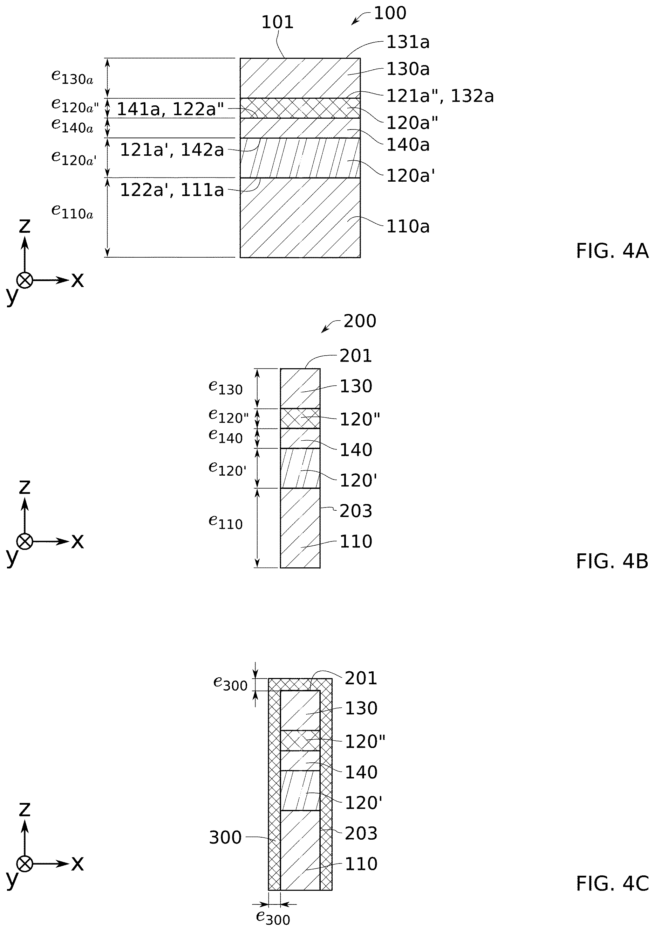

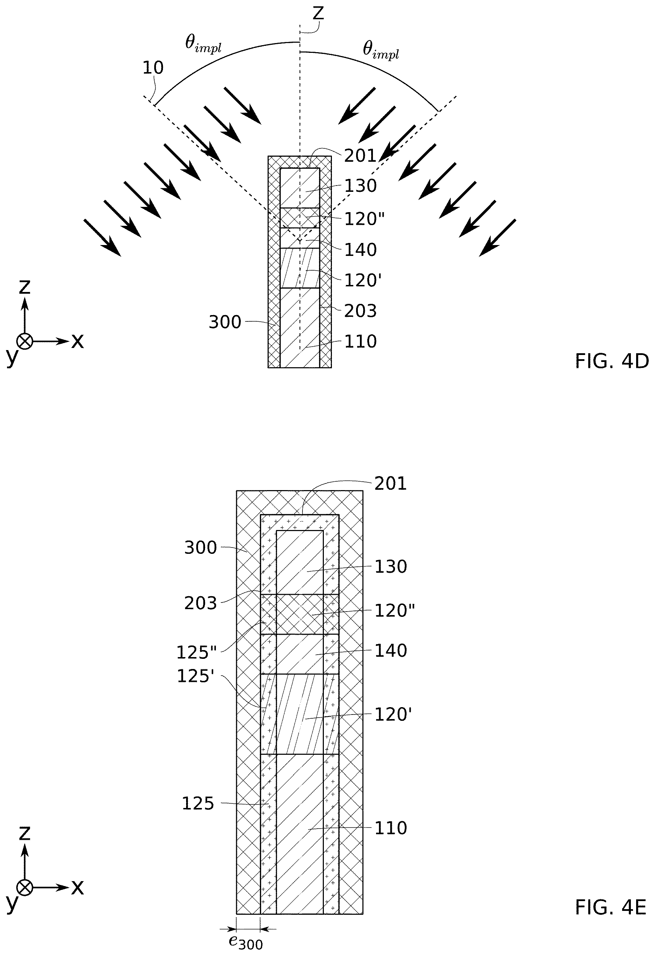

Un autre exemple de mise en oeuvre du procédé selon l'invention va maintenant être décrit en référence aux figures 4A à 4E.

Dans ce mode de réalisation, comme illustré à la figure 4B, le tronçon chalcogénure 120 comprend un premier tronçon chalcogénure 120' et un deuxième tronçon chalcogénure 120" séparés dans la direction d'empilement Z par une électrode intermédiaire 140.

Pour obtenir un point mémoire 200 présentant ces couches, il est possible de mettre en oeuvre les étapes décrites ci-dessous.

L'empilement 100 fourni initialement comprend, selon cet exemple, empilées selon une direction d'empilement Z : une couche inférieure 110a, une première couche chalcogénure 120a', une couche intermédiaire 140a, une deuxième couche chalcogénure 120a" et une couche supérieure 130a. La couche chalcogénure 120a décrite dans le premier mode de réalisation comprend ainsi deux couches 120a', 120a" séparées par la couche intermédiaire 140a.

Une gravure de structuration permet ensuite d'obtenir le point mémoire 200. Comme décrit dans le cadre du premier mode de réalisation, cette gravure est avantageusement réalisée au travers d'ouvertures réalisées dans un masque de gravure 50 déposée sur la face supérieure 101 de l'empilement 100. La gravure de structuration traverse cette fois la couche supérieure 130a, la première couche chalcogénure 120a', la couche intermédiaire 140a, la deuxième couche chalcogénure 120a" sur toutes leurs épaisseurs respectives $e_{130a}$, $e_{120a"}$, $e_{140a}$ et $e_{120a'}$. La gravure de structuration peut s'arrêter dans la couche inférieure 110a, ou bien traverser entièrement cette dernière.

Suite à la gravure de structuration, on obtient un point mémoire 200 comprenant, empilés selon la direction d'empilement Z :

- une électrode inférieure 110 formée dans au moins une partie de la couche inférieure 110a,
- un premier tronçon chalcogénure 120' formé dans la première couche chalcogénure 120a',
- une électrode intermédiaire 140 formée dans la couche intermédiaire 140a,
- un deuxième tronçon chalcogénure 120" formé dans la deuxième couche chalcogénure 120a", et
- une électrode supérieure 130 formée dans la couche supérieure 130a.

Les épaisseurs $e_{130}$, $e_{120"}$, $e_{140}$ et $e_{120'}$ selon la direction d'empilement Z de ces électrodes et tronçons sont chacune sensiblement égale à l'épaisseur $e_{130a}$, $e_{120a"}$, $e_{140a}$ et $e_{120a'}$ de la couche à partir de laquelle ils ont été formés. L'épaisseur $e_{110}$ de l'électrode inférieure 110 dépend de la profondeur de la gravure dans la couche inférieure 110a.

Le deuxième tronçon chalcogénure 120" est couramment désigné couche sélectrice. La couche sélectrice est de préférence destinée à rester amorphe.

Une couche peut être disposée entre le deuxième tronçon chalcogénure 120", ou couche sélectrice, et l'électrode intermédiaire 140 et/ou l'électrode supérieure 130, par exemple une couche à base de carbone, configurée pour bloquer l'interdiffusion des éléments chimiques entre ces couches.

Comme dans le premier mode de réalisation, le point mémoire 200 présente une face supérieure 201 et une surface latérale 203, dont les caractéristiques décrites dans le cadre du premier mode de réalisation se transposent ici mutatis mutandis.

De façon similaire à ce qui a été décrit pour le premier mode de réalisation, le point mémoire 200 est ensuite encapsulé par une couche d'encapsulation 300 (figure 4C), puis est soumis à l'implantation d'une espèce dopante (figure 4D). Les caractéristiques et avantages décrits dans le cadre du premier mode de réalisation s'étendent mutatis mutandis au cas où le point mémoire 200 comprend deux tronçons chalcogénures 120 séparés par une électrode intermédiaire.

Avantageusement, dans ce mode de réalisation, la portion dopée 125 s'étend à la fois dans le premier tronçon chalcogénure 120' et dans le deuxième tronçon chalcogénure 120". La portion dopée 125 comprend alors une première portion dopée 125', s'étendant dans le premier tronçon chalcogénure 120', et une deuxième portion dopée 125", s'étendant dans le deuxième tronçon chalcogénure 120".

La première portion dopée 125' du premier tronçon chalcogénure 120' s'étend de préférence selon la direction d'empilement Z sur au moins 50%, et de manière avantageuse au moins 75%, de l'épaisseur $e_{120'}$ du premier tronçon chalcogénure 120. Préférentiellement, la première portion dopée 125' s'étend sur toute l'épaisseur $e_{120'}$ du premier tronçon chalcogénure 120'.

De façon similaire, la deuxième portion dopée 125" du deuxième tronçon chalcogénure 120" s'étend de préférence selon la direction d'empilement Z sur au moins 50%, et de manière avantageuse au moins 75%, de l'épaisseur $e_{120"}$ du deuxième tronçon chalcogénure 120". Préférentiellement, la deuxième portion dopée 125" s'étend sur toute l'épaisseur $e_{120"}$ du deuxième tronçon chalcogénure 120'.

Les remarques développées sur le profil d'implantation s'appliquent parfaitement à ce mode de réalisation.

On présente ci-dessous les avantages de l'implantation selon l'invention. Les avantages décrits en référence au tronçon chalcogénure s'appliquent aussi bien au cas où ce dernier comprend une couche mémoire qu'au cas où il comprend à la fois une couche mémoire et une couche sélectrice. Les avantages propres à chacun de ces deux cas de figures sont spécifiquement mentionnés.

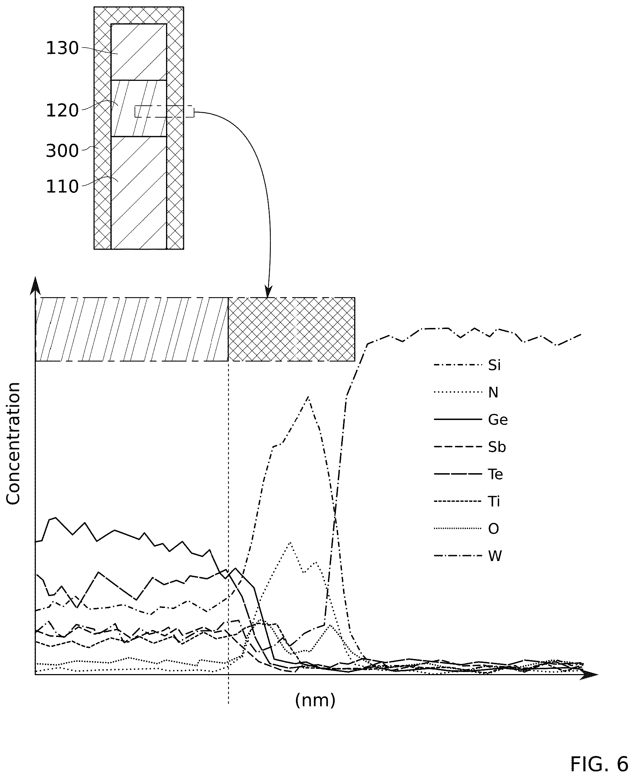

L'étape d'implantation a pour conséquence l'introduction d'un pic de la concentration de l'espèce dopante à l'interface entre la couche d'encapsulation 300 et le point mémoire 200. Par exemple, la concentration atomique en espèce dopante au niveau de cette interface peut atteindre 5 at.%. L'implantation a également pour effet d'introduire un gradient latéral ou tout autre profil en concentration d'espèce dopante à partir de la surface latérale 203 et vers l'intérieur du point mémoire 200. Cela permet de limiter la déplétion d'espèces chalcogénures que l'on peut observer sur la figure 6 illustrant l'évolution de la concentration de différentes espèces dans une tranche d'un dispositif PCM de l'art antérieur comprenant une portion de la couche mémoire et de la couche d'encapsulation. On observe sur cette figure une déplétion en Ge induite par l'oxydation ayant lieu à la remise à l'air après gravure. Une implantation, par exemple de carbone, permet de réduire voire d'empêcher la ségrégation du Ge (ou toute autre espèce chalcogénure), qui est liée à la nucléation hétérogène ayant lieu à l'interface entre la couche d'oxyde de germanium (GeOx) et le matériau chalcogénure lui-même. Cela a pour effet une réduction du phénomène de séparation de phase, qui peut elle-même provoquer une réduction de possibles phénomènes de déplétion élémentaire.

Cette implantation au niveau de l'interface entre le point mémoire 200 et la couche d'encapsulation 300 et sur la portion dopée 125 a pour effet de détruire les liaisons se formant entre les espèces chalcogénures et des atomes d'oxygène à cause notamment de la remise à l'air du point mémoire entre la gravure de structuration et l'encapsulation. A la place des liaisons chalcogénure-oxyde ($Ge-O$, $TeO_2$, $Sb_2O_3$...), on forme des liaisons entre les espèces chalcogénures et l'espèce dopante ($Ge-C$, $Ge-As$...). Ces liaisons sont, contrairement aux liaisons oxyde, bénéfiques au fonctionnement du dispositif 1. Elles permettent notamment un phénomène de passivation de la portion dopée 125. Cela a pour avantage de retarder la cristallisation des régions pauvres en espèces chalcogénures, coïncidant typiquement avec la portion dopée 125. Le retard à la cristallisation assure une meilleure uniformité et moins de variabilité des cristaux de matériau chalcogénure, alors que des cristaux plus gros et orientés de façon non homogène, typique de dispositifs non implantés, induisent une variabilité intrinsèque.

L'implantation permet également une relaxation structurale du matériau à la base du tronçon chalcogénure 120. Cela a pour effet une baisse de la densité du dispositif PCM 1, notamment au niveau de l'interface entre le point mémoire 200 la couche d'encapsulation 300.

La présence de l'espèce dopante permet également de rendre le tronçon chalcogénure moins impacté par la ségrégation cristalline entre les éléments chimiques le composant. Cela a pour avantage de fiabiliser la programmation de l'état SET.

L'étape d'implantation à partie de la face supérieure 101 et de la surface latérale 203 du point mémoire permet également d'améliorer la propreté de l'interface entre le point mémoire 200 et la couche d'encapsulation 300. Cela permet de réduire voire même d'éviter de potentiels effets parasites de dégénération du matériau constituant le tronçon chalcogénure aux interfaces avec la couche d'encapsulation 300. Cela permet également d'améliorer l'adhérence entre le point mémoire 200 et la couche d'encapsulation 300. L'implantation provoque en outre une réduction du stress interne du tronçon chalcogénure dans son état amorphe, notamment au niveau de son interface avec la couche d'encapsulation 300. Cela permet une relaxation des contraintes dans cette région, ayant elle-même pour bénéfice une réduction des défauts structuraux créés dans cette région, et ce jusqu'à la fin de l'intégration du dispositif PCM 1.

La présence de l'espèce dopante dans le tronçon chalcogénure 120 ou couche mémoire, notamment à proximité de l'interface avec la couche d'encapsulation 300, permet d'en améliorer les performances thermiques, notamment grâce à une réduction de la conductivité thermique. La cristallisation des espèces chalcogénures est par ailleurs rendue plus uniforme grâce à cette réduction de la conductivité thermique. En effet, suite à l'émission d'une impulsion électrique pour la programmation de l'état SET, la chaleur est évacuée plus lentement. Le processus de cristallisation de la couche mémoire est donc amélioré et rendu plus homogène. Pour la couche mémoire, la variabilité de l'état SET est ainsi diminuée. Pour la couche sélectrice, la variabilité de la tension de seuil et de la tension d'initialisation est diminuée.

Les différents avantages de l'implantation décrits ci-dessus ont pour conséquences positives générales sur le dispositif PCM :

- Une amélioration du nombre de cycles durant lesquels le dispositif PCM 1 peut fonctionner avec des performances supérieures à des spécifications données. Cela équivaut à une amélioration de l'endurance du dispositif 1.
- Le fait d'atteindre des performances équivalentes à celles obtenues dans l'art antérieur pour de grandes dimensions (typiquement une largeur prise selon l'axe Y comprise entre 50 et 300 nm), cette fois pour des dimensions réduites du point mémoire 200 (notamment une largeur du point mémoire prise selon l'axe Y inférieure ou égale à 50 nm).

Il est entendu que les avantages décrits ci-dessus relativement à l'étape d'implantation du procédé selon l'invention s'étendent naturellement à la présence de la portion dopée 125 dans le dispositif selon l'invention.

Des dimensions du dispositif PCM 1 sont maintenant données à titre d'exemple non limitatif, en référence aux figures 2, 3F et 4C. Le dispositif PCM 1 peut présenter une largeur $L_1$ selon la direction y sensiblement comprise entre 5 nm et 100 nm. L'électrode inférieure 110 peut présenter une épaisseur $e_{110}$ sensiblement comprise entre 30 nm et 200 nm, par exemple sensible égale à 100 nm. Le cas échéant (figure 4C), l'électrode intermédiaire 140 peut présenter une épaisseur $e_{140}$ sensiblement comprise entre 2 et 50 nm, par exemple sensiblement égale à 20 nm. L'électrode supérieure 130 peut présenter une épaisseur $e_{130}$ sensiblement comprise entre 10 nm et 100 nm, par exemple sensiblement égale à 50 nm. Le tronçon chalcogénure (figure 3F) peut présenter une épaisseur sensiblement comprise entre 10 nm et 100 nm, par exemple sensiblement égale à 50 nm. Le cas échéant (figure 4C), le premier tronçon chalcogénure 120' peut présenter une épaisseur sensiblement comprise entre 10 nm et 100 nm, par exemple sensiblement égale à 50 nm. Le cas échéant, le premier tronçon chalcogénure 120" peut présenter une épaisseur sensiblement comprise entre 5 nm et 50 nm, par exemple sensiblement égale à 25 nm.

Exemples particuliers de réalisation

Des résultats obtenus pour des dispositifs PCM 1 comprenant une électrode inférieure 110, un tronçon chalcogénure ou couche mémoire 110, une électrode supérieure 120 et une couche d'encapsulation 300, comme par exemple illustré par la figure 3F, vont maintenant être décrits. Les dimensions de ce dispositif 1 correspondent aux dimensions décrites précédemment. Dans ces exemples la couche mémoire 110 est faite de $Ge_2Sb_2Te_5$, la couche d'encapsulation de SiN et l'espèce dopante est du carbone.

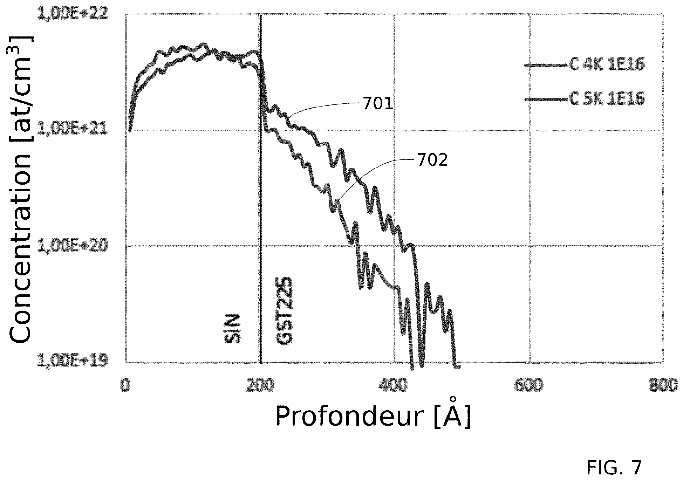

La figure 7 représente les profils d'implantation (concentration en at/cm$^3$) obtenus par simulation TRIM pour une dose de carbone de $10^{16}$ at/cm$^2$ et deux valeurs distinctes d'énergie d'implantation (4keV 701 et 5keV 702), en fonction de la profondeur dans une tranche du dispositif 1 s'étendant depuis le flanc extérieur de la couche d'encapsulation 300 et jusque dans la couche mémoire. Pour les deux énergies d'implantation on observe une densité importante de carbone à l'interface entre la couche d'encapsulation 300 en SiN et le tronçon chalcogénure 120, puis que la concentration du carbone dans le tronçon chalcogénure 120 décroit avec la distance à l'interface PCM/encapsulation, sur une quinzaine de nanomètres. A l'interface, la densité de carbone est d'environ 5 at.%.

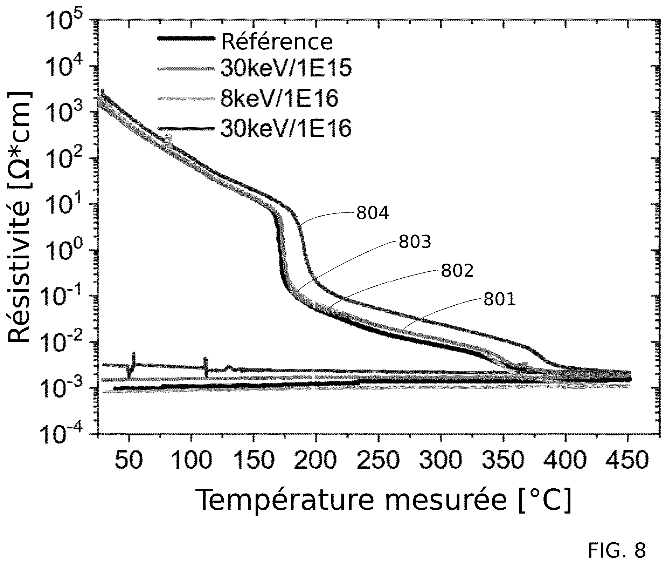

La figure 8 illustre des mesures de résistivité (en Ω·cm) en fonction de la température (en °C) de couches mémoires amorphes implantées selon un profil uniforme avec du carbone pour différentes énergies d'implantation (8 keV ou 30 keV) et doses implantées ($10^{15}$ ou $10^{16}$ at/cm$^2$). On observe une augmentation de la température de cristallisation pour les exemples implantés à plus forte dose et plus forte énergie. Cela confirme une amélioration de la stabilité de la phase amorphe vis-à-vis de la cristallisation grâce à la présence du carbone.

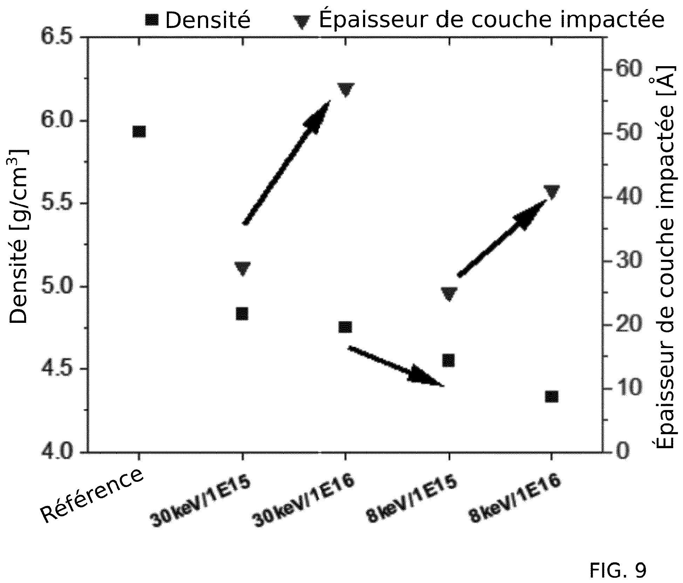

La figure 9 illustre des mesures de densité (en g/cm$^3$) et d'épaisseur dopée ou implantée (correspondant à la dimension radiale $l_{125}$) (en Å) de couches mémoires amorphes implantées avec du carbone pour différentes énergies d'implantation (8 keV ou 30 keV) et doses implantées ($10^{15}$ ou $10^{16}$ at/cm$^2$), ainsi qu'une mesure de densité (en g/ cm$^3$) d'une couche mémoire amorphe non implantée (référence). On observe que l'implantation en carbone permet de réduire de plus d'une unité la densité de la couche mémoire, quelle que soit la dose implantée et l'énergie d'implantation, sur une épaisseur comprise entre 2 nm et 6 nm depuis l'interface avec la couche d'encapsulation 300. L'augmentation de la dose implantée permet tout particulièrement de réduire la densité. Ces éléments confirment que l'implantation permet une relaxation structurale et ainsi une réduction de la densité du tronçon chalcogénure.

A travers les différents modes de réalisation décrits ci-dessus, il apparaît clairement que l'invention propose un procédé de fabrication d'un dispositif mémoire en améliorant les propriétés.

L'invention n'est pas limitée aux modes de réalisations précédemment décrits et s'étend à tous les modes de réalisation couverts par les revendications. Notamment, le dispositif PCM peut présenter toute caractéristique résultant de la mise en oeuvre du procédé et inversement le procédé peut comprendre toute étape configurée pour l'obtention d'une caractéristique du dispositif.

## Revendications

1. Dispositif (1) mémoire à changement de phase comprenant un empilement (100) comprenant un point mémoire (200), le point mémoire (200) comprenant, empilés selon une direction dite verticale (Z) :

   i. une électrode inférieure (110) formée dans une couche inférieure (110a),
   ii. au moins un tronçon dit chalcogénure (120) formé dans au moins une couche chalcogénure (120a), disposé sur l'électrode inférieure (110),
   iii. une électrode supérieure (130) formée dans une couche supérieure (130a) et disposée sur l'au moins un tronçon chalcogénure (120),
   le point mémoire (200) présentant une surface latérale (203) et une face supérieure (201),

   le point mémoire comprenant en outre :

   - une couche d'encapsulation (300) encapsulant le point mémoire (200) et disposée au contact de la surface latérale (203) et de la face supérieure (201), la couche d'encapsulation (300) étant à base d'au moins un matériau pris parmi le SiN, le SiC et le SiCN,
   - au moins une portion (125), dite dopée, s'étendant depuis la surface latérale (203) et à l'intérieur du tronçon chalcogénure (120), et présentant un dopage à base d'au moins une espèce, dite espèce dopante, choisie parmi les espèces suivantes : le carbone, le fluor, l'azote, l'indium, l'arsenic, l'aluminium, le germanium, le silicium, le chlore et le bore, la portion dopée (125) s'étendant, selon la direction verticale (Z), le long de toute la hauteur du tronçon chalcogénure (120), le tronçon chalcogénure (120) présentant une portion dite non dopée (126) présentant un dopage nul ou inférieur au dopage de la portion dopée (125) en l'espèce dopante, la portion dite non dopée (126) s'étendant depuis la portion dopée (125) et jusqu'à un centre du tronçon chalcogénure (120), **caractérisé en ce que** la couche d'encapsulation (300) présente un dopage à base de ladite espèce dopante.

2. Dispositif (1) selon la revendication précédente, dans lequel l'espèce dopante de l'au moins une portion dopée (125) présente un pourcentage atomique supérieur à 0,5%.

3. Dispositif (1) selon l'une quelconque des revendications précédentes, dans lequel la portion dopée (125) présente selon toutes les directions d'un plan transversal (XY) perpendiculaire à la direction verticale (Z) une dimension radiale $l_{125}$ avec $l_{125} \leq 20$ nm, de préférence $l_{125} \leq 10$ nm.

4. Dispositif (1) selon l'une quelconque des revendications précédentes, dans lequel la portion dopée (125) présente selon toutes les directions d'un plan transversal (XY) perpendiculaire à la direction verticale (Z) une dimension radiale $l_{125}$ avec $l_{125} \geq 2$ nm, de préférence $l_{125} \geq 5$ nm.

5. Dispositif (1) selon l'une quelconque des revendications précédentes, dans lequel le point mémoire (200) présente une hauteur $H_{200}$ selon la direction d'empilement (Z), la portion dopée (125) s'étendant selon la direction d'empilement (Z) sur au moins 50%, de préférence au moins 75%, de la hauteur $H_{200}$ du point mémoire (200).

6. Dispositif (1) selon l'une quelconque des revendications précédentes, dans lequel la couche d'encapsulation (300) présente une épaisseur $e_{300}$ comprise entre 10 nm et 30 nm.

7. Dispositif (1) selon l'une quelconque des revendications précédentes, dans lequel la portion dopée (125) présente un gradient en espèce dopante depuis sa surface latérale (203) jusqu'à la portion dite non dopée (126).

8. Dispositif (1) selon l'une quelconque des revendications précédentes, dans lequel le pourcentage atomique de l'espèce dopante au sein de la portion dopée (125) est sensiblement constant selon la direction d'empilement (Z).

9. Procédé de fabrication d'un dispositif (1) mémoire à changement de phase comprenant les étapes suivantes :

   • une fourniture d'un empilement (100) présentant une face supérieure (101), l'empilement (100) comprenant, empilées selon une direction dite verticale (Z) :

   i. une couche inférieure (110a),
   ii. au moins une couche dite chalcogénure (120a) à base d'au moins un élément chimique de la famille des chalcogènes,
   iii. une couche supérieure (130a),

   • une gravure de structuration de l'empilement (100) à partir de sa face supérieure (101), la gravure de structuration s'étendant jusque dans une partie au moins de la couche inférieure (110a) et permettant de former un point mémoire (200) comprenant :

i. une électrode inférieure (110) formée dans la couche inférieure (110a),
ii. au moins un tronçon dit chalcogénure (120) formé dans l'au moins une couche chalcogénure (120a), disposé sur l'électrode inférieure (110),
iii. une électrode supérieure (130) formée dans la couche supérieure (130a) et disposée sur l'au moins un tronçon chalcogénure (120),
le point mémoire (200) présentant une surface latérale (203) et une face supérieure (201),

• une formation d'une couche d'encapsulation (300) encapsulant le point mémoire (200) et disposée au contact de la surface latérale (203) et de la face supérieure (201) du point mémoire (200), la couche d'encapsulation (300) étant à base d'au moins un matériau pris parmi le SiN, le SiC et le SiCN,
• une implantation ionique d'une espèce dite dopante, choisie parmi les espèces suivantes : le carbone, le fluor, l'azote, l'indium, l'arsenic, l'aluminium, le germanium, le silicium, le chlore et le bore, dans la couche d'encapsulation (300) et dans l'au moins un tronçon chalcogénure (120) au travers de la couche d'encapsulation (300), l'implantation ionique étant réalisée selon une direction d'implantation (10) formant un angle dit d'implantation $\theta_{impl}$ avec la direction verticale (Z), avec $\theta_{impl} \geq 25°$, l'implantation ionique étant configurée de façon à doper au moins une portion (125) dite dopée du tronçon chalcogénure (120), la portion dopée (125) s'étendant depuis la surface latérale (203), et à ne pas doper ou à doper à un dopage inférieur au dopage de la portion dopée (125) une portion (126) dite non dopée s'étendant depuis la portion dopée (125) et jusqu'à un centre du tronçon chalcogénure (120).

10. Procédé selon la revendication précédente dans lequel $25° \leq \Theta_{impl} \leq 60°$.

11. Procédé selon l'une quelconque des revendications 9 et 10 dans lequel l'au moins un tronçon chalcogénure (120) comprend un premier tronçon chalcogénure (120') et un deuxième tronçon chalcogénure (120") :

• le premier tronçon chalcogénure (120') est disposé sur l'électrode inférieure (100), et destiné à former une couche dite mémoire, et
• le deuxième tronçon chalcogénure (120") est destiné à former une couche dite sélectrice, le deuxième tronçon chalcogénure (120") étant séparé du premier tronçon chalcogénure (120') par une électrode intermédiaire (140), et
• l'implantation ionique est configurée de sorte que la portion (125) du tronçon chalcogénure (120) s'étende dans le premier tronçon chalcogénure (120') et le deuxième tronçon chalcogénure (120").

12. Procédé selon l'une quelconque des revendications 9 à 11 dans lequel lors de l'implantation ionique, l'énergie d'implantation est supérieure ou égale à 1 keV, de préférence supérieure ou égale à 4 keV, de préférence supérieure ou égale à 10 keV, par exemple supérieure ou égale à 30 keV.

13. Procédé selon l'une quelconque des revendications 9 à 12 dans lequel lors de l'implantation ionique, une dose d'espèce dopante $D_{imp}$ supérieure à $10^{15}$ atomes/cm$^2$ est implantée.

14. Procédé selon l'une quelconque des revendications 9 à 13, dans lequel le tronçon chalcogénure (120) comprend au moins un élément chimique parmi le germanium, l'antimoine et le tellure.

15. Procédé selon l'une quelconque des revendications 9 à 14 en combinaison avec la revendication 11 dans lequel le deuxième tronçon chalcogénure (120") comprend au moins un élément chimique parmi le sélénium, l'arsenic, le soufre, le silicium et l'aluminium.

**Patentansprüche**

1. Phasenwechsel-Speichervorrichtung (1), die einen Stapel (100) umfasst, der einen Speicherpunkt (200) umfasst, wobei der Speicherpunkt (200) Folgendes in einer vertikalen Richtung (Z) gestapelt umfasst:

i. eine untere Elektrode (110), die in einer unteren Schicht (110a) ausgebildet ist,
ii. mindestens einen Chalkogenidabschnitt (120), der in mindestens einer Chalkogenidschicht (120a) ausgebildet und auf der unteren Elektrode (110) angeordnet ist,
iii. eine obere Elektrode (130), die in einer oberen Schicht (130a) ausgebildet und auf dem mindestens einen Chalkogenidabschnitt (120) angeordnet ist,
wobei der Speicherpunkt (200) eine Seitenfläche (203) und eine Oberseite (201),
wobei der Speicherpunkt ferner Folgendes umfasst:

- eine Einkapselungsschicht (300), die den Speicherpunkt (200) einkapselt und in Kontakt mit der Seitenfläche (203) und der Oberseite (201) angeordnet ist, wobei die Einkapselungsschicht (300) auf mindestens einem Material aus SiN, SiC und SiCN basiert,

- mindestens einen dotierten Abschnitt (125), der sich von der Seitenfläche (203) aus und innerhalb des Chalkogenidabschnitts (120) erstreckt und eine Dotierung auf Basis von mindestens einer Art, der Dotierungsart, aufweist, die aus den folgenden Arten ausgewählt ist: Kohlenstoff, Fluor, Stickstoff, Indium, Arsen, Aluminium, Germanium, Silizium, Chlor und Bor, wobei sich der dotierte Abschnitt (125) in vertikaler Richtung (Z) entlang der gesamten Höhe des Chalkogenidabschnitts (120) erstreckt, wobei der Chalkogenidabschnitt (120) einen nicht dotierten Abschnitt (126) aufweist, der keine oder eine geringere Dotierung aufweist als die Dotierung des dotierten Abschnitts (125) in der Dotierungsart, wobei sich der nicht dotierte Abschnitt (126) vo, dem dotierten Abschnitt (125) aus und bis zu einem Mittelpunkt des Chalkogenidabschnitts (120) erstreckt, **dadurch gekennzeichnet, dass** die Einkapselungsschicht (300) eine Dotierung auf der Basis der Dotierungsart aufweist.

2. Vorrichtung (1) nach dem vorhergehenden Anspruch, wobei die Dotierungsart des mindestens einen dotierten Abschnitts (125) einen atomaren Prozentsatz von mehr als 0,5 % aufweist.

3. Vorrichtung (1) nach einem der vorhergehenden Ansprüche, wobei der dotierte Abschnitt (125) in allen Richtungen einer zur vertikalen Richtung (Z) senkrechten Querebene (XY) eine radiale Abmessung $l_{125}$ aufweist, wobei $l_{12,5} \leq 20$ nm, vorzugsweise $l_{125} \leq 10$ nm.

4. Vorrichtung (1) nach einem der vorhergehenden Ansprüche, wobei der dotierte Abschnitt (125) in allen Richtungen einer zur vertikalen Richtung (Z) senkrechten Querebene (XY) eine radiale Abmessung $l_{125}$ aufweist, wobei $l_{125} \geq 2$ nm, vorzugsweise $l_{125} \geq 5$ nm.

5. Vorrichtung (1) nach einem der vorhergehenden Ansprüche, wobei der Speicherpunkt (200) eine Höhe $H_{200}$ in Stapelrichtung (Z) aufweist, wobei sich der dotierte Abschnitt (125) in Stapelrichtung (Z) um mindestens 50 %, vorzugsweise mindestens 75 %, der Höhe $H_{200}$ des Speicherpunkts (200) erstreckt.

6. Vorrichtung (1) nach einem der vorhergehenden Ansprüche, wobei die Einkapselungsschicht (300) eine Dicke $e_{300}$ zwischen 10 nm und 30 nm aufweist.

7. Vorrichtung (1) nach einem der vorhergehenden Ansprüche, wobei der dotierte Abschnitt (125) einen Dotierungsartgradienten von seiner Seitenfläche (203) bis zu dem nicht dotierten Abschnitt (126) aufweist.

8. Vorrichtung (1) nach einem der vorhergehenden Ansprüche, wobei der atomare Prozentsatz der Dotierungsart innerhalb des dotierten Abschnitts (125) im Wesentlichen konstant in Stapelrichtung (Z) ist.

9. Verfahren zum Herstellen einer Phasenwechsel-Speichervorrichtung (1), das die folgenden Schritte umfasst:

• Bereitstellen eines Stapels (100), der eine Oberseite (101) aufweist, wobei der Stapel (100) Folgendes in einer vertikalen Richtung (Z) gestapelt umfasst:

i. eine untere Schicht (110a),
ii. mindestens eine Chalkogenidschicht (120a) auf Basis von mindestens einem chemischen Element der Chalkogenfamilie,
iii. eine obere Schicht (130a),

• Strukturierungsgravieren des Stapels (100) von seiner Oberseite (101) aus, wobei sich das Strukturierungsgravieren bis zu einem Teil mindestens der unteren Schicht (110a) erstreckt und es ermöglicht, einen Speicherpunkt (200) zu bilden, umfassend:

i. eine untere Elektrode (110), die in der unteren Schicht (110a) ausgebildet ist,
ii. mindestens einen Chalkogenidabschnitt (120), der in der mindestens einen Chalkogenidschicht (120a) ausgebildet und auf der unteren Elektrode (110) angeordnet ist,
iii. eine obere Elektrode (130), die in der oberen Schicht (130a) ausgebildet und auf dem mindestens einen Chalkogenidabschnitt (120) angeordnet ist,

wobei der Speicherpunkt (200) eine Seitenfläche (203) und eine Oberseite (201),
• Bilden einer Einkapselungsschicht (300), die den Speicherpunkt (200) einkapselt und in Kontakt mit der Seitenfläche (203) und der Oberseite (201) des Speicherpunkts (200) angeordnet ist, wobei die Einkapselungsschicht (300) auf mindestens einem Material aus SiN, SiC und SiCN basiert,
• Ionenimplantation einer Dotierungsart, die aus den folgenden Arten ausgewählt ist: Kohlenstoff, Fluor, Stickstoff, Indium, Arsen, Aluminium, Germanium, Silizium, Chlor und Bor, in die Einkapselungsschicht (300) und in den mindestens einen Chalkogenidabschnitt (120) durch die Einkapselungsschicht (300), wobei die Ionenimplantation gemäß einer Implantationsrichtung (10) durchgeführt wird, die mit der vertikalen Richtung (Z) einen Implantationswinkel $\theta_{impl}$ bildet, wobei $\theta_{impl} \geq 25°$, wobei die Ionenimplantation so konfiguriert ist, dass sie mindestens einen dotierten Abschnitt (125) des Chalkogenidabschnitts (120) dotiert, wobei sich der dotierte Abschnitt (125) von der Seitenfläche (203) aus erstreckt, und einen nicht dotierten Abschnitt (126), der sich von dem dotierten Abschnitt (125) aus bis zu einem Mittelpunkt des Chalkogenidabschnitts (120) erstreckt, nicht dotiert oder mit einer geringeren Dotierung als die Dotierung des dotierten Abschnitts (125) dotiert.

10. Verfahren nach dem vorhergehenden Anspruch, wobei $25° \leq \theta_{impl} \leq 60°$.

11. Verfahren nach einem der Ansprüche 9 und 10, wobei der mindestens eine Chalcogenidabschnitt (120) einen ersten Chalcogenidabschnitt (120') und einen zweiten Chalcogenidabschnitt (120") umfasst:

    • der erste Chalkogenidabschnitt (120') ist auf der unteren Elektrode (100) angeordnet und dazu bestimmt, eine Speicherschicht zu bilden, und
    • der zweite Chalkogenidabschnitt (120") ist dazu bestimmt, eine selektive Schicht zu bilden, wobei der zweite Chalkogenidabschnitt (120") durch eine Zwischenelektrode (140) von dem ersten Chalkogenidabschnitt (120') getrennt ist, und
    • die Ionenimplantation ist so konfiguriert, dass sich der Abschnitt (125) des Chalkogenidabschnitts (120) in den ersten Chalkogenidabschnitt (120') und den zweiten Chalkogenidabschnitt (120") erstreckt.

12. Verfahren nach einem der Ansprüche 9 bis 11, wobei die Implantationsenergie bei der Ionenimplantation größer oder gleich 1 keV, vorzugsweise größer oder gleich 4 keV, vorzugsweise größer oder gleich 10 keV, beispielsweise größer oder gleich 30 keV, ist.

13. Verfahren nach einem der Ansprüche 9 bis 12, wobei bei der Ionenimplantation eine Dosis der Dotierungsart $D_{imp}$ von mehr als $10^{15}$ Atomen/cm² implantiert wird.

14. Verfahren nach einem der Ansprüche 9 bis 13, wobei der Chalkogenidabschnitt (120) mindestens ein chemisches Element aus Germanium, Antimon und Tellur umfasst.

15. Verfahren nach einem der Ansprüche 9 bis 14 in Kombination mit Anspruch 11, wobei der zweite Chalkogenidabschnitt (120") mindestens ein chemisches Element aus Selen, Arsen, Schwefel, Silizium und Aluminium umfasst.

## Claims

1. A phase change memory device (1) comprising a stack (100) comprising a memory point (200), the memory point (200) comprising, stacked in a vertical direction (Z):

    i. a lower electrode (110) formed in a lower layer (110a),
    ii. at least one chalcogenide section (120) formed in at least one chalcogenide layer (120a), disposed on the lower electrode (110),
    iii. an upper electrode (130) formed in an upper layer (130a) and disposed on the at least one chalcogenide section (120),
    wherein the memory point (200) has a side surface (203) and an upper face (201),
    the memory point further comprising:

        - an encapsulation layer (300) encapsulating the memory point (200) and disposed in contact with the side surface (203) and with the upper face (201), the encapsulation layer (300) being composed of at least one material selected from SiN, SiC, and SiCN,
        - at least one doped portion (125), extending from the side surface (203) and inside the chalcogenide section (120), and having doping with a basis of at least one doping species selected from the group consisting of carbon, fluorine, nitrogen, indium, arsenic, aluminium, germanium, silicon, chlorine, and boron, wherein the doped portion (125) extends, in the vertical direction (Z), along the entire height of the chalcogenide section (120), the chalcogenide section (120) having a non-doped portion (126) having a zero doping, or a doping less than the doping of the doped portion (125) in the doping species, and wherein the non-doped portion (126) extends from the doped portion (125) and up to a centre of the chalcogenide section (120), **characterised in that** the encapsulation layer (300) has doping with a basis of said doping species.

**2.** Device (1) according to the preceding claim, wherein the doping species of at the least one doped portion (125) has an atomic percentage greater than 0.5%.

**3.** Device (1) according to any one of the preceding claims, wherein the doped portion (125) has, in all the directions of a transverse plane (XY) perpendicular to the vertical direction (Z), a radial dimension $l_{125}$ with $l_{125} \leq 20$ nm, preferably $l_{125} \leq 10$ nm.

**4.** Device (1) according to any one of the preceding claims, wherein the doped portion (125) has, in all the directions of a transverse plane (XY) perpendicular to the vertical direction (Z), a radial dimension $l_{125}$ with $l_{125} \geq 2$ nm, preferably $l_{125} \geq 5$ nm.

**5.** Device (1) according to any one of the preceding claims, wherein the memory point (200) has a height $H_{200}$ in the stack direction (Z), and wherein the doped portion (125) extends in the stack direction (Z) over at least 50%, and preferably at least 75%, of the height $H_{200}$ of the memory point (200).

**6.** Device (1) according to any one of the preceding claims, wherein the encapsulation layer (300) has a thickness $e_{300}$ of between 10 nm and 30 nm.

**7.** Device (1) according to any one of the preceding claims, wherein the doped portion (125) has a gradient of doping species from its side surface (203) up to the non-doped portion (126).

**8.** Device (1) according to any one of the preceding claims, wherein the atomic percentage of the doping species within the doped portion (125) is substantially constant in the stack direction (Z).

**9.** A method for manufacturing a phase change memory device (1) comprising the following steps:

   • providing a stack (100) having an upper face (101), the stack (100) comprising, stacked in a so-called vertical direction (Z):

      i. a lower layer (110a),
      ii. at least one so-called chalcogenide layer (120a) with a basis of at least one chemical element of the chalcogenide family,
      iii. an upper layer (130a),

   • patterning etching of the stack (100) from its upper face (101), the patterning etching extending up into at least one part of the lower layer (110a) and making it possible to form a memory point (200) comprising:

      i. a lower electrode (110) formed in the lower layer (110a),

      ii. at least one so-called chalcogenide section (120) formed in the at least one chalcogenide layer (120a), disposed on the lower electrode (110),
      iii. an upper electrode (130) formed in the upper layer (130a) and disposed on the at least one chalcogenide section (120),

   wherein the memory point (200) has a side surface (203) and an upper face (201),
   • forming an encapsulation layer (300) encapsulating the memory point (200) and disposed in contact with the side surface (203) and with the upper face (201) of the memory point (200), the encapsulation layer (300) being composed of at least one material selected from SiN, SiC, and SiCN,
   • ion implanting a doping species, selected from the group consisting of carbon, fluorine, nitrogen, indium, arsenic, aluminium, germanium, silicon, chlorine, and boron, in the encapsulation layer (300) and in the at least one chalcogenide section (120) through the encapsulation layer (300), wherein the implantation is done in an implantation direction (10) forming an implantation angle $\theta_{impl}$ with the vertical direction (Z), with $\theta_{impl} \geq 25°$, wherein the ion implantation is configured to dope at least one doped portion (125) of the chalcogenide section (120), wherein the doped portion (125) extends from the side surface (203), and to not dope or to dope at a doping less than the doping of the doped portion (125), a non-doped portion (126) extends from the doped portion (125) and up to a centre of the chalcogenide section (120).

**10.** Method according to the preceding claim, wherein

$$25°{\leq}\theta_{impl} \leq 60°.$$

**11.** Method according to any one of claims 9 and 10, wherein the at least one chalcogenide section (120) comprises a first chalcogenide section (120') and a second chalcogenide section (120"):

   • wherein the first chalcogenide section (120') is disposed on the lower electrode (100) and configured to form a memory layer, and
   • wherein the second chalcogenide section (120") is configured to form a selective layer, the second chalcogenide section (120") being separated from the first chalcogenide section (120') by an intermediate electrode (140), and
   • wherein the ion implantation is configured such that portion (125) of the chalcogenide section (120) extends into the first chalcogenide section (120') and the second chalcogenide section (120").

12. Method according to any one of claims 9 to 11, wherein during the ion implantation, the implantation energy is greater than or equal to 1 keV, preferably greater than or equal to 4 keV, preferably greater than or equal to 10 keV, for example greater than or equal to 30 keV.

13. Method according to any one of claims 9 to 12, wherein during the ionic implantation, a dose of doping species $D_{imp}$ greater than $10^{15}$ atoms/cm$^2$ is implanted.

14. Method according to any one of claims 9 to 13, wherein the chalcogenide section (120) comprises at least one chemical element selected from the group consisting of germanium, antimony and tellurium.

15. Method according to any one of claims 9 to 14 in combination with claim 11, wherein the second chalcogenide section (120") comprises at least one chemical element selected from the group consisting of selenium, arsenic, sulphur, silicon and aluminium.

FIG. 1

FIG. 2

FIG. 3A

FIG. 3B

FIG. 3C

FIG. 3D

FIG. 3E

FIG. 3F

$\theta_{impl}$    $\theta_{impl}$

10

201

130

120

200    203

300

110

Z

Z

Y ⊗ → X

FIG. 3G

201

200

125

A    203

120

300

Z

Y ⊗ → X

FIG. 3H

FIG. 3I

FIG. 4A

FIG. 4B

FIG. 4C

FIG. 4D

FIG. 4E

FIG. 5A

FIG. 5B

FIG. 5C

FIG. 6

FIG. 7

FIG. 8

FIG. 9

**RÉFÉRENCES CITÉES DANS LA DESCRIPTION**

**Documents brevets cités dans la description**

- US 2020052039 A1
- US 2020075675 A1
- US 10454025 B1
- CN 112786784 A
- US 2012295398 A1